# EUROPEAN PATENT APPLICATION

(11) **EP 2 530 756 A1**
(43) Date of publication of application: **05.12.2012**
(21) Application number: 11737006.4
(22) Date of filing: 26.01.2011
(51) Int. Cl.: H01L 41/083, F02M 51/00, F02M 51/06, H01L 41/187, H01L 41/22, H02N 2/00

(54) **LAMINATED PIEZOELECTRIC ELEMENT, MANUFACTURING METHOD OF SAME, INJECTION DEVICE PROVIDED WITH LAMINATED PIEZOELECTRIC ELEMENT, AND FUEL INJECTION SYSTEM**

(30) Priority: 26.01.2010 JP 2010014077
(71) Applicant: Kyocera Corporation, Kyoto-shi, Kyoto 612-8501 (JP)
(72) Inventor: HANADA,Katsuhiko, Kagoshima 899-4396 (JP)
(74) Representative: Viering, Jentschura & Partner
(86) International application number: PCT/JP2011/051389
(87) International publication number: WO 2011/093293

(57) **Abstract**

Provided are a laminated piezoelectric element which is equipped with a covered layer that is capable of alleviating a stress generated by expansion and contraction of a laminated body and is prevented from peeling off even due to a long drive, a manufacturing method thereof, an injection device equipped with the laminated piezoelectric element, and a fuel injection system.

The laminated piezoelectric element has laminated body (7) which is formed by laminating a plurality of piezoelectric layers (3) and a plurality of internal electrode layers (5) and causing part of end faces of the internal electrode layers (5) to reach a side surface thereo. On the side surface of the laminated body (7), a pair of external electrodes (8) is alternatively electrically connected to the internal electrode layers (5) every other layer. In at least part where the pair of external electrodes (8) is not provided, an inorganic material layer (11) is adhered to the side surfaces of the laminated body (7) so as to cover the end surfaces of the internal electrode layers (5), and between the inorganic material layer (11) and the side surface of the laminated body (7), air holes (12) are formed.

## Description

### Technical Field

The present invention relates to a multilayer piezoelectric element used as a piezoelectric drive element (piezoelectric actuator), a pressure sensor element, a piezoelectric circuit element, or the like, a method for producing the same, an injection device including the multilayer piezoelectric element, and a fuel injection system.

### Background Art

A known multilayer piezoelectric element includes a columnar laminate in which a plurality of piezoelectric layers and a plurality of internal electrode layers are alternately stacked and some of end faces of the internal electrode layers are exposed at side faces of the laminate, and a pair of external electrodes which adhere to the side faces of the laminate so as to extend in a stacking direction and to which alternating ones of the internal electrode layers are respectively electrically connected.

It is also known that an organic (resin) covering layer is formed on the side faces of a laminate to electrically and mechanically protect the laminate (refer to, for example, Patent Document 1).

### Related Art Document

### Patent Document

Patent Document 1: Japanese Unexamined Patent Application Publication No. 4-259268

### SUMMARY OF INVENTION

### PROBLEMS TO BE SOLVED BY THE INVENTION

Here, the covering layer has a function of suppressing the generation of electrical discharges (short-circuits) between a positive electrode and a negative electrode in the multilayer piezoelectric element or between the multilayer piezoelectric element and a metal case that encloses the multilayer piezoelectric element. An organic (resin) covering layer can conform to the expansion and contraction of the laminate as compared with an inorganic covering layer. Thus, the formation of an organic (resin) covering layer is advantageous in that a stress can be relieved.

However, the adhesion of such an organic (resin) covering layer tends to be decreased by thermal degradation due to long-term driving. Specifically, even when an organic (resin) covering layer is formed in close contact with the laminate, the covering layer tends to become separated from the laminate during long-term driving. As a result, a gap is formed by this separation between the laminate and the covering layer and this gap causes a short-circuit. Consequently, there may be a problem that the driving of the multilayer piezoelectric element becomes unstable or stops.

The present invention has been made in view of the above circumstances, and an object of the present invention is to provide a multilayer piezoelectric element including a covering layer that can relieve a stress generated by expansion and contraction of a laminate and that is not easily separated even during long-term driving, a method for producing the multilayer piezoelectric element, an injection device including the multilayer piezoelectric element, and a fuel injection system.

### MEANS FOR SOLVING THE INVENTION

A multilayer piezoelectric element of the present invention includes a columnar laminate in which a plurality of piezoelectric layers and a plurality of internal electrode layers are stacked and some of end faces of the internal electrode layers reach side faces of the laminate; a pair of external electrodes adhering to the side faces of the laminate so that alternating ones of the internal electrode layers are respectively electrically connected to the external electrodes; and an inorganic material layer adhering to the side faces of the laminate so as to cover the end faces of the internal electrode layers in regions where at least the pair of external electrodes is not provided, wherein pores are present between the inorganic material layer and the side faces of the laminate.

A piezoelectric actuator of the present invention includes the multilayer piezoelectric element of the present invention and a case that contains the multilayer piezoelectric element therein.

An injection device of the present invention includes a container having an injection hole and the multilayer piezoelectric element of the present invention, wherein a fluid stored in the container is discharged from the injection hole by driving the multilayer piezoelectric element.

A fuel injection system of the present invention includes a common rail that stores high-pressure fuel, the injection device of the present invention that injects the high-pressure fuel stored in the common rail, a pressure pump that supplies the high-pressure fuel to the common rail, and an injection control unit that provides a driving signal to the injection device.

### ADVANTAGEOUS EFFECTS OF THE INVENTION

According to the multilayer piezoelectric element of the present invention, the covering layer for suppressing short-circuits is a highly heat-resistant inorganic material layer. Thus, even when the multilayer piezoelectric element is exposed to a high temperature for a long period of time, the covering layer is not easily degraded, and a strong bonding strength (adhesion) between the covering layer and piezoelectric layers can be obtained. In addition, since the inorganic material layer has good solvent resistance, driving of the multilayer piezoelectric element in liquid can also be realized. Furthermore, since a large number of pores are present between the inorganic material layer and side faces of the laminate, a stress generated (at an interface) between the inorganic material layer and the laminate during driving can be effectively relieved. Furthermore, the pores delay the transmission of heat generated in the laminate, thereby preventing the inorganic material layer from becoming separated by expansion thereof due to a rapid increase in heat.

### BRIEF DESCRIPTION OF THE DRAWINGS

[Fig. 1] Fig. 1 is a perspective view illustrating a multilayer piezoelectric element according to an embodiment of the present invention.
[Fig. 2] Fig. 2 is a partial, enlarged, cross-sectional view in a cross section (cross section that cuts across an inorganic material layer) parallel to a stacking direction of the multilayer piezoelectric element illustrated in Fig. 1.
[Fig. 3] Fig. 3 illustrates a multilayer piezoelectric element according to another embodiment of the present invention, and is a partial, enlarged, cross-sectional view in a cross section (cross section that cuts across an inorganic material layer) parallel to a stacking direction.
[Fig. 4] Fig. 4 is an enlarged view of region A including an inorganic material layer and a porous layer illustrated in Fig. 3.
[Fig. 5] Fig. 5 is a schematic cross-sectional view illustrating a piezoelectric actuator according to an embodiment of the present invention.
[Fig. 6] Fig. 6 is a schematic cross-sectional view illustrating an injection device according to an embodiment of the present invention.
[Fig. 7] Fig. 7 is a schematic view illustrating a fuel injection system according to an embodiment of the present invention.

### EMBODIMENTS OF THE INVENTION

Embodiments of a multilayer piezoelectric element of the present invention will now be described in detail with reference to the drawings.

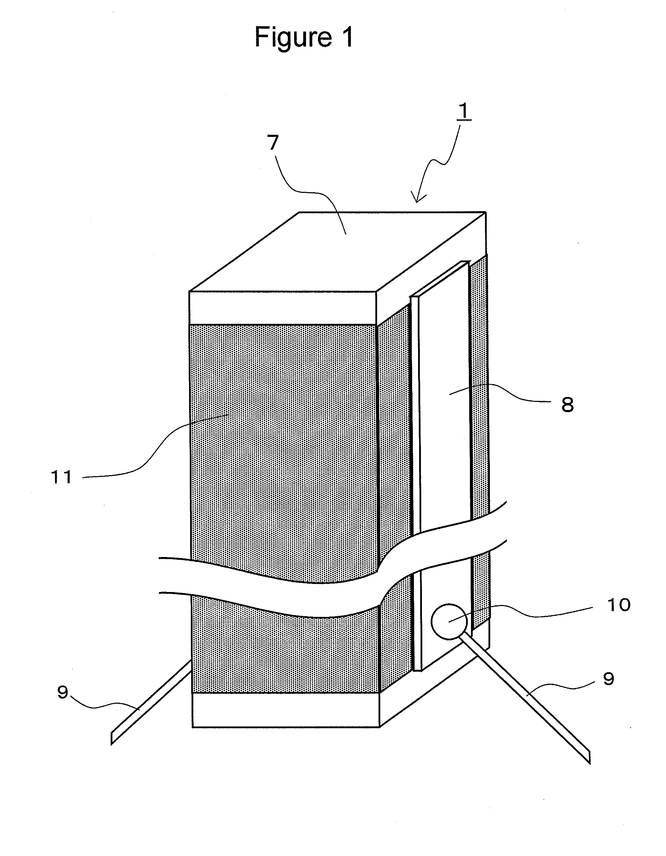

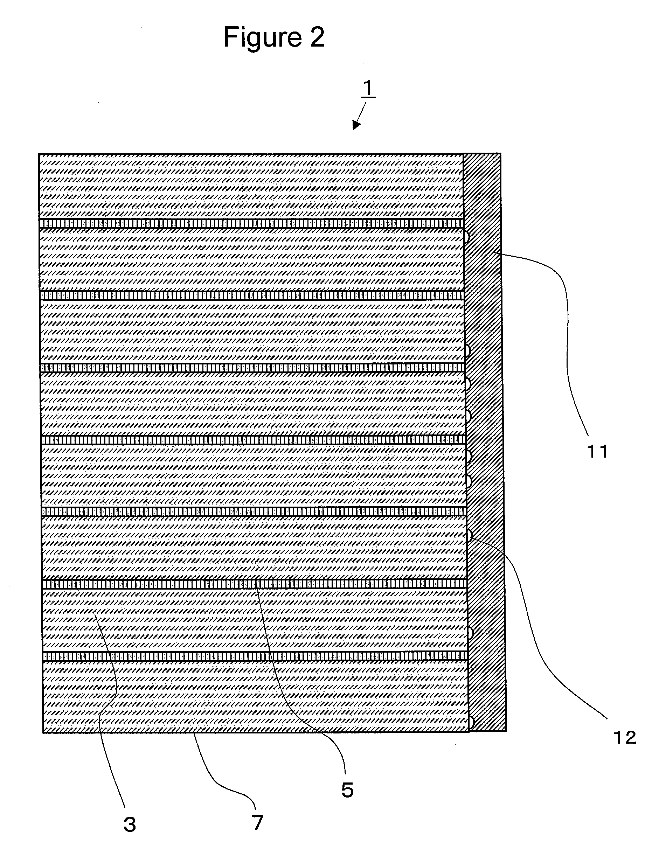

Fig. 1 is a perspective view illustrating a multilayer piezoelectric element according to an embodiment of the present invention. Fig. 2 is a partial, enlarged, cross-sectional view in a cross section (cross section that cuts across an inorganic material layer) parallel to a stacking direction of the multilayer piezoelectric element illustrated in Fig. 1.

As illustrated in Figs. 1 and 2, a multilayer piezoelectric element 1 of the embodiment includes a laminate 7 in which a plurality of piezoelectric layers 3 and a plurality of internal electrode layers 5 are stacked and some of end faces of the internal electrode layers 5 reach side faces of the laminate 7. In addition, on the side faces of the laminate 7, a pair of external electrodes 8 respectively electrically connected to alternating ones of the internal electrode layers 5. In regions where at least the pair of external electrodes 8 is not provided, an inorganic material layer 11 adheres to the side face of the laminate 7 so as to cover the end faces of the internal electrode layers 5. The multilayer piezoelectric element 1 has pores 12 between the inorganic material layer 11 and the side face of the laminate 7.

The laminate 7 illustrated in Figs. 1 and 2 includes an active portion in which the piezoelectric layers 3 and the internal electrode layers 5 are alternately stacked and inactive portions disposed on both ends of the active portion and each including a piezoelectric layer 3. Some of end faces of the internal electrode layers 5 reach side faces of the laminate 7, and the end faces each include a portion that is electrically connected to the external electrode 8 and a portion that is covered with the inorganic material layer 11.

The piezoelectric layers 3 forming the laminate 7 are composed of a piezoelectric porcelain (piezoelectric ceramic) that exhibits piezoelectricity. The piezoelectric porcelain forming the piezoelectric layers 3 is formed to have an average grain size of, for example, 1.6 to 2.8 µm. Examples of the piezoelectric porcelain that can be used include perovskite-type oxides such as PbZrO₃-PbTiO₃ (PZT: lead zirconate titanate), lithium niobate (LiNbO₃), and lithium tantalate (LiTaO₃), and the like. The laminate 7 illustrated in Fig. 1 has a quadrangular column shape. Alternatively, the laminate 7 may have, for example, a hexagonal column shape, an octagonal column shape, or the like.

The internal electrode layers 5 are alternately stacked with the piezoelectric layers 3 so as to sandwich each of the piezoelectric layers 3 in the vertical direction. A positive electrode and a negative electrode are arranged in the order of stacking so that a driving voltage is applied to a piezoelectric layer 3 interposed therebetween. The internal electrode layers 5 are composed of a metal such as a silver-palladium (Ag-Pd) alloy, copper, or platinum. In this embodiment, positive electrodes and negative electrodes (or ground electrodes) are alternately led to opposite side faces of the laminate 7, and portions of end faces of the internal electrode layers 5 are electrically connected to the pair of external electrodes 8 bonded to the side faces of the laminate 7.

The pair of external electrodes 8 is formed by applying a paste containing, for example, silver and glass and baking the paste, and adheres to opposite side faces of the laminate 2 so as to extend in the stacking direction. The external electrodes 8 are electrically connected to the internal electrode layers 5 that are alternately led to the opposite side faces of the laminate 7. In Fig. 1, the external electrode 8 is formed so that the width of the external electrode 8 is smaller than the width of the surface on which the external electrode 8 is formed. Alternatively, the width of the external electrode 8 and the width of the surface may be the same. In particular, in the case where the laminate 7 has a hexagonal column shape or an octagonal column shape, the external electrode 8 may be formed such that the width of the external electrode 8 is the same as the width of the surface having the external electrode 8 thereon.

The inorganic material layer 11 adhering to the side faces of the laminate 7 so as to cover end faces of the internal electrode layers 5 in regions where at least the pair of external electrodes 8 is not provided is formed so as to have a thickness of, for example, several micrometers to several hundred micrometers and strongly bonded to the laminate 7. Examples of the material of the inorganic material layer 11 include piezoelectric materials, glass, and alumina. In particular, a piezoelectric material same as the piezoelectric porcelain forming the piezoelectric layers 3, for example, PbZrO₃-PbTiO₃ (PZT: lead zirconate titanate) is preferably used. By forming the inorganic material layer 11 using a piezoelectric material (preferably, a piezoelectric material the same as the piezoelectric porcelain forming the piezoelectric layers 3), not only driving in liquid or in high humidity can be realized but also the inorganic material layer 11 exhibits the piezoelectric effect due to a leakage electric field (electric field generated in an area that is not sandwiched between electrodes) from the internal electrode layers 5 and can conform to expansion and contraction of the element. Herein, the phrase "adhering to the side faces of the laminate 7 so as to cover end faces of the internal electrode layers 5 in regions where at least the pair of external electrodes 8 is not provided" refers to the following. Among side faces of the laminate 7 to which some of end faces of the internal electrode layers 5 extend, in the case where side faces having external electrodes 8 thereon include areas where the end faces of the internal electrode layers 5 are not covered with the external electrodes 8, the inorganic material layer 11 adheres to the areas. Furthermore, as illustrated in Fig. 1, in the case where some of end faces of the internal electrode layers 5 reach side faces other than the side faces having the external electrodes 8 thereon, the inorganic material layer 11 may adhere to the side faces that do not have the external electrodes 8 thereon. The inorganic material layer 11 does not cover the end faces of the internal electrode layers 5 covered with the external electrode 8. However, for example, the inorganic material layer 11 may be formed so that a part of the inorganic material layer 11 is interposed between a side face of the laminate 7 and the external electrode 8 so as to overlap with a peripheral edge portion of the external electrode 8.

The plurality of pores 12 present between the inorganic material layer 11 and a side face of the laminate 7 each have a diameter of, for example, 0.3 to 1.5 µm. The pores 12 are formed so that, in cross-sectional view, the total of portions of the pores 12, the portions being in contact with the side face of the laminate 7, is, for example, 1% to 40% and preferably 10% to 20% relative to the length of the side face of the laminate 7. The presence of the plurality of (large number of) pores 12 can effectively relieve a stress (at an interface) between the inorganic material layer 11 and the laminate 7 generated during driving.

In addition, the pores 12 disturb transmission of heat generated in the laminate 7, thereby preventing the inorganic material layer 11 from becoming separated by expansion thereof due to a rapid increase in heat. The multilayer piezoelectric element 1 generates heat by expansion and contraction thereof. For example, in the case where the inorganic material layer 11 is a covering material composed of a resin instead of an inorganic material, this heat causes thermal degradation of the covering material. On the other hand, in the case where the coveting material is the inorganic material layer 11, since the inorganic material layer 11 has good thermal conductivity, rapid thermal expansion of the inorganic material layer 11 occurs, and the inorganic material layer 11 may be separated. In contrast, since the large number of pores 12, which have poor thermal conductivity, are present between the inorganic material layer 11 and the side faces of the laminate 7, transmission of heat is disturbed, thereby preventing the inorganic material layer 11 from becoming separated by expansion thereof due to a rapid increase in heat.

The plurality of pores 12 are preferably located on the side of the piezoelectric layers 3 (located between the internal electrode layers 5) rather than on the side of the internal electrode layers 5. In other words, the pores 12 are preferably located between any of the piezoelectric layers 3 and the inorganic material layer 11. The piezoelectric layers 3 are expanded and contracted by driving the multilayer piezoelectric element 1. Therefore, in the case where the pores 12 are located between any of the piezoelectric layers 3 and the inorganic material layer 11, the stress generated by the expansion and contraction of the piezoelectric layers can be more effectively relieved. The above multilayer piezoelectric element 1 has a structure in which the pores 12 are not present in regions located between any of the internal electrode layers 5 and the inorganic material layer 11 but are present only between any of the piezoelectric layers 3 and the inorganic material layer 11. However, the structure is not limited thereto. Alternatively, the multilayer piezoelectric element 1 may have a structure in which the abundance ratio of the pores 12 located between the piezoelectric layers 3 and the inorganic material layer 11 is higher than the abundance ratio of the pores 12 located between the internal electrode layers 5 and the inorganic material layer 11.

The pores 12 are preferably located in the active portion in which the piezoelectric layers 3 and the internal electrode layers 5 are alternately stacked. In particular, in the multilayer piezoelectric element 1 of this embodiment, the pores 12 are preferably located in a central portion of the laminate 7 in the stacking direction. The central portion of the laminate 7 in the stacking direction is largely expanded and contracted, as compared with end portions of the laminate 7 in the stacking direction. Therefore, in the case where the pores 12 are located in the central portion of the laminate 7 in the stacking direction, a stress can be more effectively relieved. The term "central portion" refers to a central portion when the laminate 7 is divided into three equal parts in the stacking direction. The multilayer piezoelectric element 1 has a structure in which the pores 12 are present only in the central portion, and are not present in other portions. However, the structure is not limited thereto. Alternatively, the multilayer piezoelectric element 1 may have a structure in which the abundance ratio of the pores 12 located in the central portion is higher than the abundance ratios of the pores 12 located in other portions.

The size of each of the pores 12 is preferably smaller than the average grain size of the piezoelectric porcelain forming the piezoelectric layers 3. In this case, a stress can be relieved in a more dispersed manner while ensuring insulating properties. The average size of the pores 12 and the average grain size of the piezoelectric porcelain are determined by polishing the multilayer piezoelectric element 1 in a side face direction, and observing the polished multilayer piezoelectric element 1 with an electron microscope.

Furthermore, the inorganic material layer 11 is preferably composed of a piezoelectric material. In this case, the inorganic material layer exhibits the piezoelectric effect by a leakage electric field and can conform to expansion and contraction of the element. Thus, the element can be stably driven for a longer period of time. In particular, from the standpoint of the bonding strength, the inorganic material layer 11 and the piezoelectric layers 3 are preferably composed of the same piezoelectric material.

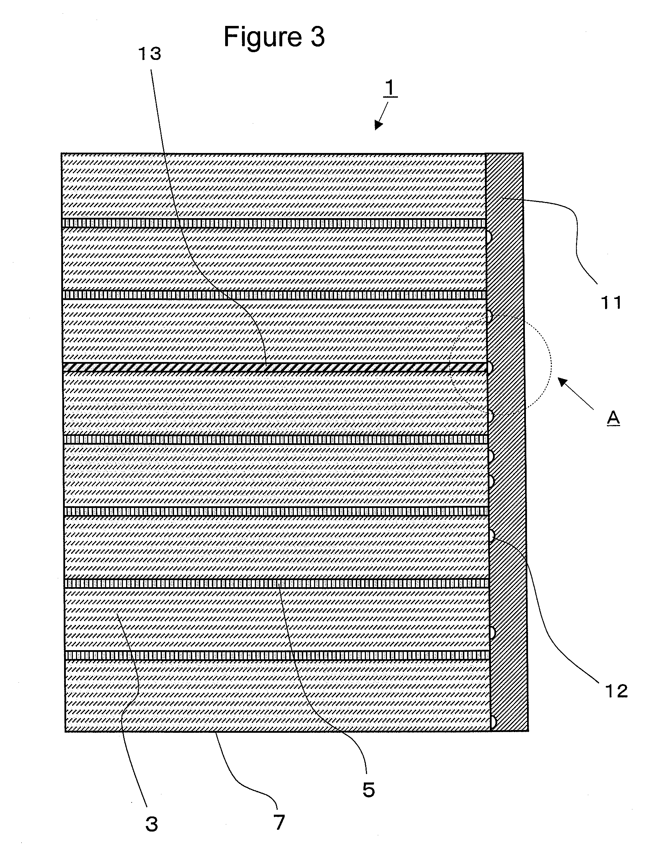

In the laminate 7, in place of some of the plurality of internal electrode layers 5, a porous layer 13 composed of a conductor layer having a plurality of pores, for example, may be arranged as illustrated in Fig. 3. The porous layer 13 has a strength lower than the strength of the internal electrode layers 5, and cracks are easily formed in the porous layer 13 by a stress. Accordingly, breaking of the porous layer 13 due to cracks or the like is caused by a stress generated in the laminate 7 during driving prior to the breaking of the internal electrode layers 5. Thus, the porous layer 13 functions as a layer that relieves a stress in the laminate 7.

As just described, the porous layer 13 is provided in the laminate 7 and a plurality of pores are present between the porous layer 13 and the inorganic material layer 11 (a plurality of pores are located on the side of the porous layer 13). In this case, even if cracks are formed in the porous layer 13 when the porous layer 13 relieves a stress of the laminate 7, the cracks can be selectively induced to a region of the inorganic material layer 11 located on the side of the porous layer 13. Accordingly, cracks are not formed in a region of the inorganic material layer 11 located on the side of an internal electrode layer 5 (region facing an end of an internal electrode layer 5), and thus electrical discharges on the surface of the inorganic material layer 11 can be suppressed.

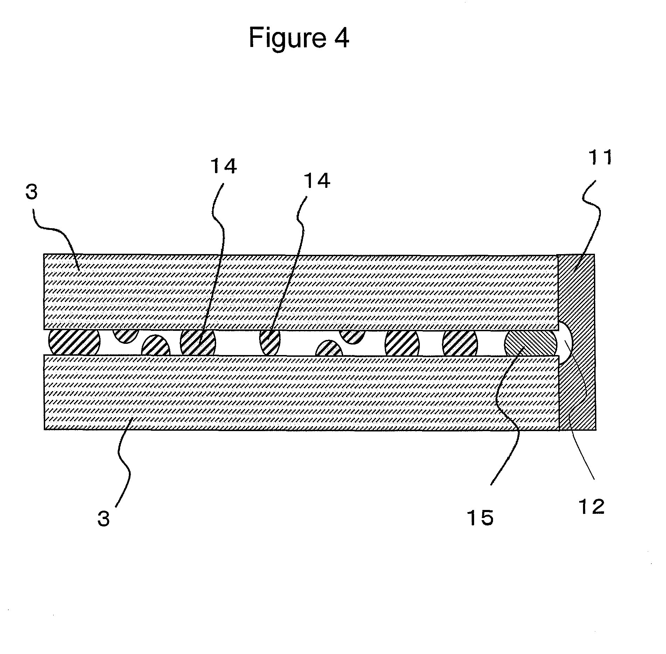

As illustrated in Fig. 4, preferably, the porous layer 13 is mainly composed of metal particles separated with gaps therebetween, and particles 15 composed of the same material as the inorganic material layer 11 are present in the porous layer 13. With this structure, among stresses applied to the porous layer 13, a stress having a high impact velocity can be absorbed by distortion of a crystal lattice of the particles 15 composed of the same material of the inorganic material layer 11, and a stress having a low impact velocity but having a high impact strength can be absorbed by deformation of the shapes of the metal particles 14.

The metal particles 14 each have a particle diameter of 0.1 to 50 µm, for example. This value can be determined by observing a cross section with an electron microscope such as a scanning electron microscope (SEM) or a metallurgical microscope, measuring the number of spaces between particles included in an arbitrary line segment and the distances between the particles, measuring the number of particles included in the arbitrary line segment and the length of the line segment included in each of the particles, and dividing the total of the length of the line segment by the number of particles.

The distance formed by the gap between the metal particles 14 is 1 to 100 µm, for example. This value can be determined by observing a cross section with an electron microscope such as a scanning electron microscope (SEM) or a metallurgical microscope, measuring the number of spaces between particles included in an arbitrary line segment and the distances between the particles, and dividing the total of the distance between the particles by the number of spaces between the particles.

The particles 15 composed of the same material as the inorganic material layer 11 and present in the porous layer 13 have a size of 0.05 to 50 µm, for example, and are preferably scattered. Herein, the phrase "the particles 15 are scattered in the porous layer 13" means that when a cross section is observed with an electron microscope such as a scanning electron microscope (SEM) or a metallurgical microscope, a plurality of particles 15 are dispersed together with the metal particles 14 with gaps therebetween.

In particular, by arranging a particle 15 composed of the same material as the inorganic material layer 11 so as to contact a pore 12 located between the porous layer 13 and the inorganic material layer 11, a stress-absorbing effect similar to that in the porous layer 13 is generated in a region of the inorganic material layer 11 located on the side of the porous layer 13, and a stress of the laminate 7 can be relieved. Furthermore, when crack are formed inside the porous layer 13, the cracks are formed in the particles 15 composed of the same material as the inorganic material layer 11 and, at the same time, the cracks can be selectively induced to a region of the inorganic material layer 11 located on the side of the porous layer 13. Thus, the particles 15 are continuously broken along the porous layer 13, whereby the cracks can be induced to the inorganic material layer 11 in a direct line. As a result, cracks are not formed in a region of the inorganic material layer 11, the region facing an end of an internal electrode layer 5, and thus electrical discharges on the surface of the inorganic material layer 11 can be suppressed.

Next, an example of a method for producing the multilayer piezoelectric element 1 of this embodiment will be described.

First, piezoelectric green sheets to be formed into piezoelectric layers 3 are prepared. Specifically, a calcined powder of a piezoelectric ceramic, a binder composed of an organic polymer such as an acrylic polymer or a butyral polymer, and a plasticizer are mixed to prepare a ceramic slurry. Then, piezoelectric green sheets are prepared by a tape forming method such as a doctor blade method or a calender roll method using the ceramic slurry. Any piezoelectric ceramic that exhibits piezoelectricity can be used. Examples thereof includes perovskite-type oxides such as lead zirconate titanate (PZT: PbZrO₃-PbTiO₃), lithium niobate (LiNbO₃), and lithium tantalate (LiTaO₃). Examples of the plasticizer include dibutyl phthalate (DBP) and dioctyl phthalate (DOP).

Next, an internal electrode paste to be formed into internal electrode layers 5 is prepared. Specifically, for example, a binder and a plasticizer are added to and mixed with a metal powder composed of a silver-palladium (Ag-Pd) alloy to prepare an internal electrode paste. Alternatively, a silver powder and a palladium powder may be mixed instead of using the silver-palladium alloy.

Then, the internal electrode paste is applied onto the piezoelectric green sheets so as to form a pattern of the internal electrode layers 5 by a screen printing method, for example.

In the case where a porous layer is provided, in order to form a plurality of pores in a conductor layer functioning as the porous layer, a conductive paste for a porous layer, the conductive paste containing a substance that is removed or evaporated during firing, e.g., acrylic beads or the like, is prepared, and the conductive paste is applied by a screen printing method. In this case, the pattern of the porous layer may be formed over the entire surface of a cross section perpendicular to the stacking direction of a laminate 7, or may be formed as a partial pattern. From the standpoint of reliably preventing the generation of a short-circuit between a pair of external electrodes 8, the pattern is preferably formed as a pattern in which the external electrodes 8 functioning as a positive electrode and a negative electrode are divided by a non-forming portion.

Next, a predetermined number of the piezoelectric green sheets having the internal electrode paste thereon are stacked to prepare a laminated formed body. In this step, a columnar laminated formed body is prepared in which a plurality of piezoelectric green sheets and a plurality of internal electrode paste layers are alternately stacked and some end faces of the internal electrode paste layers reach side faces of the laminated formed body. Piezoelectric green sheets on which the conductive paste for a porous layer is applied may be stacked at predetermined intervals (with a predetermined number of piezoelectric green sheets therebetween). The laminated formed body may be prepared by arranging, on each of the top and the bottom of the laminated formed body, a piezoelectric green sheet that does not have the conductive paste thereon.

Next, an inorganic material paste to be formed into an inorganic material layer 11 is applied onto side faces of the laminated formed body to which end faces of the internal electrode paste layers extend so as to cover the end faces of the internal electrode layers 5. The inorganic material paste is prepared by mixing an inorganic material powder, a solvent, and a binder. Subsequently, a uniform film is formed on the side faces of the laminated formed body by a method such as screen printing, dipping, or dispenser coating. The inorganic material paste is applied onto an area other than an area where an external electrode paste described below is to be applied.

In order to form pores 12 at an interface between the side faces of the laminate 7 and the inorganic material layer 11, a binder such as ethyl cellulose, containing a solid material, such as acrylic beads, a carbon powder, or the like, which is removed or evaporated during firing is preferably applied onto the side faces of the laminated formed body before the inorganic material paste to be formed into the inorganic material layer 11 is applied. In this case, portions that contain the solid material (such as acrylic beads or a carbon powder) which is removed or evaporated during firing become the pores 12 after firing. By adjusting the average particle diameter of the acrylic beads, the carbon powder, or the like, pores having a diameter of, for example, about 0.3 to 1.5 µm can be formed in a uniformly dispersed manner at the interface between the side faces of the laminate 7 and the inorganic material layer 11. Furthermore, by adjusting the proportion of the acrylic beads, the carbon powder, or the like, the abundance ratio (distribution) of the pores can be controlled.

The binder containing a solid material that is removed or evaporated during firing is applied not over the entire side faces of the laminate 7 but partially applied, whereby the pores 12 can be formed at positions between the internal electrode layers 5 or in the central portion of the laminate 7 in the stacking direction. Furthermore, by applying the solid material (such as acrylic beads or a carbon powder) which is removed or evaporated during firing so that the proportion of the solid material is made different in different portions, the abundance ratio (distribution) of the pores can be adjusted. In order to apply the binder in this manner, portions where the application of the binder is unnecessary (for example, regions located on the side faces of the internal electrode layers) may be masked, and the binder may then be applied by a screen printing method. The application may be performed a plurality of times for various masking portions.

In the above method, a binder, such as ethyl cellulose containing a solid material that is removed or evaporated during firing is applied onto side faces of the laminated formed body. Alternatively, a solid material (such as acrylic beads or a carbon powder) which is removed or evaporated during firing may be mixed with the inorganic material paste to be formed into the inorganic material layer 11 to the extent that cracks are not formed in the inorganic material layer 11 so that the advantages of the present invention are not impaired, and thus the pores 12 may be formed at an interface between the side faces of the laminate 7 and the inorganic material layer 11.

In order to form a plurality of (a large number of) pores between the porous layer 13 and the inorganic material layer 11, prior to the application of the inorganic material paste, a binder, such as ethyl cellulose, containing acrylic beads, a carbon powder, or the like is applied onto a side face of the laminated formed body, or the laminated formed body is immersed in a container containing the binder. Subsequently, the laminated formed body in this state is placed in a container such as a desiccator, and the pressure in the container is reduced to 0.1 atm (about 10 kPa) with a vacuum pump. Thus, the acrylic beads, the carbon powder, or the like can be infiltrated in the porous layer 13 together with the binder. Subsequently, the inorganic material paste is applied, and the resulting laminated formed body is then fired. Thus, a plurality of pores can be formed between the porous layer 13 and the inorganic material layer 11.

Furthermore, in order to obtain the porous layer 13 which is mainly composed of metal particles separated with gaps therebetween, and in which particles 15 composed of the same material as the inorganic material layer 11 are scattered therein, prior to the application of the inorganic material paste, a binder, such as ethyl cellulose, containing acrylic beads, a carbon powder, or the like is applied onto a side face of the laminated formed body, or the laminated formed body is immersed in a container containing the binder. Subsequently, the laminated formed body in this state is placed in a container such as a desiccator, and the pressure in the container is reduced to 0.1 atm (about 10 kPa) with a vacuum pump. Thus, the acrylic beads, the carbon powder, or the like is infiltrated in the porous layer 13 together with the binder. Subsequently, the inorganic material paste is applied, and the resulting laminated formed body is then again placed in the container such as a desiccator, and the pressure in the container is reduced to 0.1 atm (about 10 kPa) with a vacuum pump so that the components of the inorganic material paste are dispersed in the porous layer 13. The laminated formed body is then fired to obtain the porous layer 13.

In the case where a large amount of a binder such as ethyl cellulose containing acrylic beads, a carbon powder, or the like, is added to the inorganic material paste, the porous layer 13 can be also obtained by applying the inorganic material paste is applied without applying acrylic beads, a carbon powder, or the like in advance, placing the resulting laminated formed body in a container such as a desiccator to reduce the pressure therein to 0.1 atm (about 10 kPa) with a vacuum pump so that the components of the inorganic material paste are dispersed in the porous layer 13, and by firing the laminated formed body.

The laminated formed body on which the inorganic material paste is applied is subjected to a debinding treatment at a determined temperature, and is then fired at a temperature in a range of 900°C to 1,200°C to prepare a columnar laminate 7 in which the piezoelectric layers 3 and the internal electrode layers 5 are alternately stacked and the inorganic material layer 11 adheres to the side faces of the laminate 7.

Next, a polishing process is performed on side faces of the laminate 7 obtained by firing. Specifically, a pair of regions of the inorganic material layer 11 is partly removed so as to extend in the stacking direction of the laminate 7, thus alternately exposing end faces of the internal electrode layers 5. For example, the side faces of the laminate 7 are ground in a direction parallel to the internal electrode layers 5 with a surface grinder or a polygon machine using a grindstone having a grain size of #200 to #1000 until the laminate 7 has a predetermined shape. Subsequently, the amount of cut of the grindstone is reduced to preferably 50 µm or less and more preferably 5 µm or less, and a polishing process is performed a plurality of times (preferably three times or more).

Subsequently, the external electrode paste is printed as a pattern of the external electrodes 8 so as to cover the regions where the internal electrode layers 5 are exposed, and is then baked at 650°C to 750°C to form the external electrodes 8. As for the external electrode paste, for example, a silver glass conductive paste containing silver as a main component and glass is preferred.

The method for forming the inorganic material layer 11 and the external electrodes 8 includes, instead of steps of: applying an inorganic material paste onto side faces of a laminated formed body at which end faces of internal electrode paste layers are exposed so as to cover the side faces; firing the laminated formed body having the inorganic material paste thereon to obtain a columnar laminate in which piezoelectric layers and internal electrode layers are alternately stacked and an inorganic material layer adheres to side faces; partly removing a pair of regions of the inorganic material layer, the regions extending in a stacking direction of the laminate, to alternately expose the internal electrode layers; and applying an external electrode paste so as to cover the regions where the internal electrode layers are exposed, steps of: applying an inorganic material paste onto side faces of a laminated formed body at which end faces of internal electrode paste layers are exposed, the side faces not including regions where an external electrode paste is to be applied, so as to cover the side faces; firing the laminated formed body having the inorganic material paste thereon to obtain a columnar laminate in which piezoelectric layers and internal electrode layers are alternately stacked and an inorganic material layer adheres to side faces except for in the regions where the external electrode paste is to be applied; and applying the external electrode paste so as to cover the regions where the internal electrode layers are exposed and the external electrode paste is to be applied.

Next, external lead members 9 are connected and fixed to the surfaces of the external electrodes 8 with a conductive bonding material (solder) 10 therebetween.

Subsequently, a direct current electric field of 0.1 to 3 kV/mm is applied from the external lead members 9 connected to the pair of external electrodes 8 to the piezoelectric layers 3 through the external electrodes 8 and the internal electrode layers 5 to polarize the piezoelectric layers 3 of the laminate 7. Thus, a multilayer piezoelectric element 1 is produced. Each of the piezoelectric layers 3 of this multilayer piezoelectric element 1 can be significantly displaced due to the inverse piezoelectric effect by connecting the external electrodes 8 to an external power supply through the external lead members 9 and applying a driving voltage to the piezoelectric layers 3 through the internal electrode layers 5. Thus, the multilayer piezoelectric element 1 can function as, for example, a fuel injection valve for an automobile, which injects and supplies fuel to an engine.

Examples of the applications of the multilayer piezoelectric element 1 of this embodiment include piezoelectric drive elements (piezoelectric actuators), pressure sensor elements, and piezoelectric circuit elements. Examples of the piezoelectric drive elements include a fuel injection device of an automobile engine, a liquid ejection device such as an ink jet, a precise positioning device such as an optical device, and a vibration control device. Examples of the pressure sensor element include a combustion pressure sensor, a knocking sensor, an acceleration sensor, a load sensor, an ultrasonic sensor, a pressure sensor, and a yaw rate sensor. Examples of the piezoelectric circuit element include a piezoelectric gyro, a piezoelectric switch, a piezoelectric transducer, and a piezoelectric breaker.

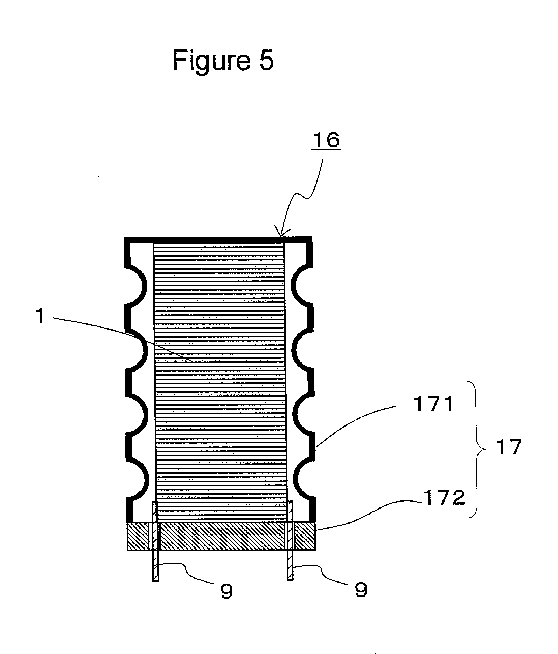

Next, a piezoelectric actuator according to an embodiment of the present invention will be described. Fig. 5 is a schematic cross-sectional view illustrating a piezoelectric actuator according to an embodiment of the present invention.

As illustrated in Fig. 5, in a piezoelectric actuator 16 of this embodiment, a multilayer piezoelectric element 1 is contained in a case 17.

Specifically, the case 17 includes a case body 171 having a closed upper end and an open lower end, and a cover 172 that is attached to the case body 171 so as to cover the opening of the case body 171. The multilayer piezoelectric element 1 is enclosed in the case 17 with, for example, an inert gas so that end faces of the multilayer piezoelectric element 1 contact the inner wall of the upper end and inner wall of the lower end of the case 17.

The case body 171 and the cover 172 are each composed of a metal material such as SUS 304 or SUS 316L.

The case body 171 is a cylinder having a closed upper end and an open lower end, and has, for example, a bellows shape so that the case body 171 can be expanded and contracted in the stacking direction of a laminate 7. The cover 172 has, for example, a plate shape so as to cover the opening of the case body 171. Two through-holes for inserting external lead members 9 are formed in the cover 172. The external lead members 9 are inserted in the through-holes so that external electrodes 8 and the outside are electrically connected to each other. Gaps of the through-holes are filled with soft glass or the like, thereby fixing the external lead members 9 and preventing infiltration of outside air.

According to the piezoelectric actuator 16 of this embodiment, each of the piezoelectric layers 3 can be largely displaced due to the inverse piezoelectric effect by connecting to an external power supply through the external lead members 9 and applying a driving voltage to the piezoelectric layers 3 through the internal electrode layers 5. Thus, the multilayer piezoelectric element can function as a piezoelectric actuator and can be stably driven for a long period of time.

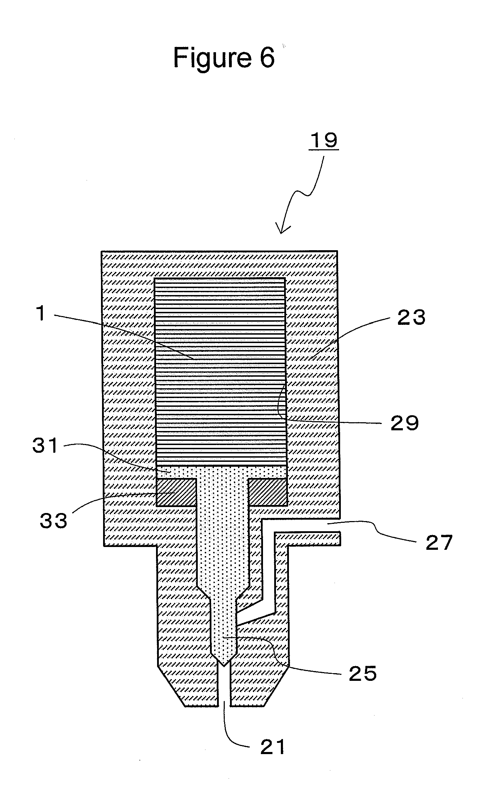

Next, an injection device according to an embodiment of the present invention will be described. Fig. 6 is a schematic cross-sectional view illustrating an injection device according to an embodiment of the present invention.

As illustrated in Fig. 6, in an injection device 19 of this embodiment, the multilayer piezoelectric element 1 described in the above embodiment is contained inside a housing (case) 23 having an injection hole 21 at an end thereof.

A needle valve 25 that can open and close the injection hole 21 is provided in the housing 23. A fluid path 27 is provided so as to communicate with the injection hole 21 in accordance with the movement of the needle valve 25. The fluid path 27 is connected to an external fluid supply source, and a fluid is constantly supplied to the fluid path 27 at a high pressure. Accordingly, when the needle valve 25 opens the injection hole 21, the fluid supplied to the fluid path 27 is discharged from the injection hole 21 to the outside or to an adjacent container, for example, a combustion chamber (not illustrated) of an internal-combustion engine.

An upper end of the needle valve 25 has a large inner diameter, and a cylinder 29 formed in the housing 23 and a slidable piston 31 are arranged on the upper end of the needle valve 25. The multilayer piezoelectric element 1 of the present invention described in the above embodiment is contained in the housing 23.

In this injection device 19, when the multilayer piezoelectric element 1 is expanded by an application of a voltage, the piston 31 is pressed and the needle valve 25 blocks the fluid path 27 leading to the injection hole 21. Thus, the supply of the fluid is stopped. When the application of the voltage is stopped, the multilayer piezoelectric element 1 is contracted, and a disc spring 33 pushes back the piston 31. Consequently, the fluid path 27 is opened, and the injection hole 21 communicates with the fluid path 27. Thus, the fluid is injected from the injection hole 21.

It may be configured so that the fluid path 27 is opened by applying a voltage to the multilayer piezoelectric element 1, and the fluid path 27 is closed by stopping the application of the voltage.

Alternatively, the injection device 19 of this embodiment may include a container 23 having an injection hole 21 and the multilayer piezoelectric element 1 described in the above embodiment, wherein a fluid charged in the container 23 is discharged from the injection hole 21 by driving the multilayer piezoelectric element 1. That is, the multilayer piezoelectric element 1 need not be provided in the container 23, and it is sufficient that a pressure for controlling the injection of the fluid is applied to the inside of the container 23 by driving the multilayer piezoelectric element 1. In the injection device 19 of this embodiment, the term "fluid" refers to not only fuel, an ink, and the like but also various types of gas and liquid such as a conductive paste. The flow rate and injection timing of a fluid can be stably controlled for a long period of time by using the injection device 19 of this embodiment.

By using the injection device 19 of this embodiment including the multilayer piezoelectric element 1 described in the above embodiment in an internal-combustion engine, fuel can be stably injected to a combustion chamber of an internal-combustion engine such as an engine with high accuracy for a longer period of time, as compared with known injection devices.

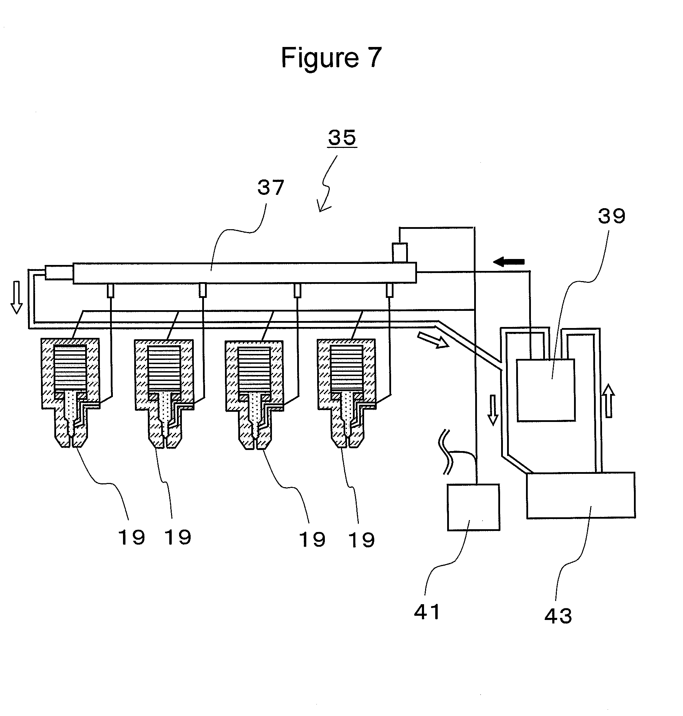

Next, a fuel injection system according to an embodiment of the present invention will be described. Fig. 7 is a schematic view illustrating a fuel injection system according to an embodiment of the present invention.

As illustrated in Fig. 7, a fuel injection system 35 of this embodiment includes a common rail 37 that stores high-pressure fuel as a high-pressure fluid, a plurality of injection devices 19 that are described in the above embodiment and that inject the high-pressure fluid stored in the common rail 37, a pressure pump 39 that supplies the high-pressure fluid to the common rail 37, and an injection control unit 41 that provides a driving signal to the injection devices 19.

The injection control unit 41 controls the amount and timing of the injection of the high-pressure fluid on the basis of external information or a signal from the outside. For example, in the case where the fuel injection system 35 of this embodiment is used for fuel injection of an engine, the amount and timing of the fuel injection can be controlled while sensing the state in a combustion chamber of the engine with a sensor or the like. The pressure pump 39 has a function of supplying fluid fuel from a fuel tank 43 to the common rail 37 at a high pressure. For example, in the fuel injection system 35 of an engine, the fluid fuel is fed to the common rail 37 at a high pressure of about 1,000 to 2,000 atm (about 101 MPa to about 203 MPa), and preferably about 1,500 to 1,700 atm (about 152 MPa to about 172 MPa). The common rail 37 stores the high-pressure fuel supplied from the pressure pump 39 and appropriately feeds the high-pressure fuel to the injection devices 19. Each of the injection devices 19 injects a certain amount of fluid from the injection hole 21 to the outside or to an adjacent container as described above. For example, in the case where the target to which fuel is injected and supplied is an engine, high-pressure fuel is injected from the injection hole 21 to a combustion chamber of the engine in the form of a mist.

The present invention is not limited to the above embodiments, and various changes can be made without departing from the gist of the present invention. For example, in the embodiment described above, the external electrodes 8 in the multilayer piezoelectric element 1 are formed on two opposite side faces of the laminate 7. Alternatively, two external electrodes 8 may be formed on adjacent side faces of the laminate 7, or on the same side face of the laminate 7. In addition, the shape of a cross section of the laminate 7 in a direction orthogonal to the stacking direction may be, instead of a quadrangular shape in the above embodiment, a polygonal shape such as a hexagonal shape or an octagonal shape, a circular shape, or a shape formed by combining straight lines and circular arcs.

### EXAMPLES

Examples of the multilayer piezoelectric element of the present invention are described below.

A piezoelectric actuator including a multilayer piezoelectric element of the present invention was prepared as follows. First, a calcined powder of a piezoelectric ceramic containing, as a main component, lead zirconate titanate (PZT: PbZrO₃-PbTiO₃) and having an average particle diameter of 0.4 µm, a binder, and a plasticizer were mixed to prepare a ceramic slurry. Ceramic green sheets to be formed into piezoelectric layers 3, the ceramic green sheets each having a thickness of 100 µm, were prepared by a doctor blade method using the ceramic slurry. A conductive paste to be formed into internal electrode layers was prepared by adding a binder to a silver-palladium alloy.

Next, the conductive paste to be formed into internal electrode layers was printed on one surface of each of the ceramic green sheets by a screen printing method. Then, the 300 ceramic green sheets on which the conductive paste was printed were stacked to prepare a laminated formed body.

Next, a binder containing acrylic beads for forming pores, the acrylic beads having an average particle diameter of 2 to 5 µm, was applied onto side faces of the laminated formed body. Subsequently, a paste prepared by adding a binder and a solvent to a calcined powder composed of the same piezoelectric ceramic as the ceramic green sheets was printed on the side faces of the laminated formed body (on the binder) by a screen printing method.

Next, firing was conducted at 980°C to 1,100°C to obtain a laminate. The laminate was ground so as to have a predetermined shape using a surface grinder. Furthermore, a pair of regions of the inorganic material layer was partly removed so as to extend in the stacking direction of the laminate, thus alternately exposing end faces of the internal electrode layers.

Next, an external electrode paste containing silver as a main component and glass was printed on the side faces to which the internal electrode layers of the laminate were led. The external electrode paste was baked at 650°C to 750°C to form external electrodes.

Lastly, external lead members were connected and fixed to a part of each of the external electrodes with solder therebetween, and a polarization treatment was then performed. Silver-containing tin-lead alloy solder having a working temperature (melting point) of 300°C was used as the solder.

Multilayer piezoelectric elements were prepared as described above.

As the multilayer piezoelectric elements, samples having different proportions of the pores were prepared. Specifically, a multilayer piezoelectric element (sample No. 1) in which pores were uniformly distributed (in a proportion of 10%) in the stacking direction in cross-sectional view, a multilayer piezoelectric element (sample No. 2) in which pores were present, in cross-sectional view, in a proportion of 20% between all the internal electrode layers and in a proportion of 10% in regions located on the side faces of the internal electrode layers, a multilayer piezoelectric element (sample No. 3) in which pores were present, in cross-sectional view, in a proportion of 20% in a central portion in the stacking direction of the laminate and in a proportion of 10% in other regions, and a multilayer piezoelectric element (sample No. 4) having no pores were prepared.

In this experiment, sample No. 1 was prepared by applying a binder having an acrylic bead content of 10%. Sample No. 2 was prepared by masking regions between the internal electrode layers and applying a binder having an acrylic bead content of 10% onto regions located on the side faces of the internal electrode layers, and then masking the regions located on the side faces of the internal electrode layers and applying a binder having an acrylic bead content of 20% onto the regions between the internal electrode layers. Sample No. 3 was prepared by masking regions other than a central portion and applying a binder having an acrylic bead content of 20% onto only the central portion, and then masking the central portion (central portion when the laminate was divided into three equal parts in the stacking direction) and applying a binder having an acrylic bead content of 10% onto other regions.

A cross section of each of the prepared multilayer piezoelectric elements cut in the stacking direction was observed with a scanning electron microscope to measure the average diameter of the pores. The average diameter of the pores was 2.2 µm. Furthermore, the cross section of each of the multilayer piezoelectric elements cut in the stacking direction was observed with a scanning electron microscope, and the proportion of the pores in a predetermined distance was determined. It was confirmed that the proportions of the pores were the values described above.

The prepared multilayer piezoelectric elements were electrically driven for 1 × 10⁸ cycles. In the multilayer piezoelectric element (sample No. 4), which had no pores, a short-circuit occurred. In contrast, in sample Nos. 1 to 3, which had pores, the generation of a short-circuit was not observed. In addition, it was found that when the number of cycles was further increased, the effects of relieving a stress and suppressing separation were maintained in sample Nos. 2 and 3, as compared with sample No. 1.

### REFERENCE SIGNS LIST

- 1: multilayer piezoelectric element
- 3: piezoelectric layer
- 5: internal electrode layer
- 7: laminate
- 8: external electrode
- 9: external lead member
- 10: solder
- 11: inorganic material layer
- 12: pore
- 13: porous layer
- 14: metal particle
- 15: particle composed of the same material as inorganic material layer
- 16: piezoelectric actuator
- 17: case
- 171: case body
- 172: cover
- 19: injection device
- 21: injection hole
- 23: housing (case)
- 25: needle valve
- 27: fluid path
- 29: cylinder
- 31: piston
- 33: disc spring
- 35: fuel injection system
- 37: common rail
- 39: pressure pump
- 41: injection control unit
- 43: fuel tank

## Claims

1. A multilayer piezoelectric element (1), comprising:
a columnar laminate (7) in which a plurality of piezoelectric layers (3) and a plurality of internal electrode layers (5) are stacked and some of end faces of the internal electrode layers (5) reach side faces of the laminate (7);
a pair of external electrodes (8) adhering to the side faces of the laminate (7) such that alternating ones of the internal electrode layers (5) are respectively electrically connected to the external electrodes (8); and
an inorganic material layer (11) adhering to the side faces of the laminate (7) to cover the end faces of the internal electrode layers (5) in regions where at least the pair of external electrodes (8) is not provided,
wherein pores (12) are present between the inorganic material layer (11) and the side faces of the laminate (7).

2. The multilayer piezoelectric element (1) according to claim 1, wherein the pores (12) are present between the piezoelectric layers (3) and the inorganic material layer (11).

3. The multilayer piezoelectric element (1) according to claim 1, wherein the pores (12) are present in a central portion in a stacking direction of the laminate (7).

4. The multilayer piezoelectric element (1) according to claim 1, wherein the size of each of the pores (12) is smaller than the average grain size of a piezoelectric porcelain forming the piezoelectric layers (3).

5. The multilayer piezoelectric element (1) according to claim 1, wherein the inorganic material layer (11) is composed of a piezoelectric material.

6. The multilayer piezoelectric element (1) according to claim 1, wherein the laminate (7) includes a porous layer (13), and the pores (12) are present between the porous layer (13) and the inorganic material layer (11).

7. The multilayer piezoelectric element (1) according to claim 1, wherein the porous layer (13) is mainly composed of metal particles (14) separated with gaps therebetween, and particles composed of the same material as the inorganic material layer (11) are present in the porous layer (13).

8. A method for producing a multilayer piezoelectric element (1), comprising:
a step of alternately stacking a plurality of piezoelectric green sheets and a plurality of internal electrode paste layers to prepare a columnar laminated formed body in which some of end faces of the internal electrode paste layers are exposed at side faces of the laminated formed body;
a step of applying an inorganic material paste onto the side faces of the laminated formed body at which the end faces of the internal electrode paste layers are exposed so as to cover the side faces;
a step of firing the laminated formed body having the inorganic material paste thereon to obtain a columnar laminate (7) in which piezoelectric layers (3) and internal electrode layers (5) are alternately stacked and an inorganic material layer (11) adheres to side faces;
a step of partly removing a pair of regions of the inorganic material layer (11), the regions extending in a stacking direction of the laminate (7), to alternately expose the internal electrode layers (5); and
a step of applying an external electrode (8) paste so as to cover the regions where the internal electrode layers (5) are exposed, and firing the laminate (7) having the external electrode (8) paste thereon to cause a pair of external electrodes (8) to which alternating ones of the internal electrode layers (5) are respectively electrically connected to adhere to the side faces of the laminate (7).

9. A method for producing a multilayer piezoelectric element (1), comprising:
a step of alternately stacking a plurality of piezoelectric green sheets and a plurality of internal electrode paste layers to prepare a columnar laminated formed body in which some of end faces of the internal electrode paste layers are exposed at side faces of the laminated formed body;
a step of applying an inorganic material paste onto the side faces of the laminated formed body at which the end faces of the internal electrode paste layers are exposed, the side faces not including regions where an external electrode (8) paste is to be applied, so as to cover the side faces;
a step of firing the laminated formed body having the inorganic material paste thereon to obtain a columnar laminate (7) in which piezoelectric layers (3) and internal electrode layers (5) are alternately stacked and an inorganic material layer (11) adheres to side faces except for in the regions where the external electrode (8) paste is to be applied; and
a step of applying the external electrode (8) paste so as to cover the regions where the internal electrode layers (5) are exposed and the external electrode (8) paste is to be applied, and firing the laminate (7) having the external electrode (8) paste thereon to cause a pair of external electrodes (8) to which alternating ones of the internal electrode layers (5) are respectively electrically connected to adhere to the side faces of the laminate (7).

10. A piezoelectric actuator, comprising:
the multilayer piezoelectric element (1) according to claim 1: and
a case that contains the multilayer piezoelectric element (1) therein.

11. An injection device, comprising:
a container having an injection hole (21); and
the multilayer piezoelectric element (1) according to claim 1,
wherein a fluid stored in the container is discharged from the injection hole (21) by driving the multilayer piezoelectric element (1).

12. A fuel injection system, comprising:
a common rail (37) that stores high-pressure fuel,
the injection device according to claim 11 that injects the high-pressure fuel stored in the common rail (37),
a pressure pump (39) that supplies the high-pressure fuel to the common rail (37); and
an injection control unit (41) that provides a driving signal to the injection device.
